# EUROPEAN PATENT APPLICATION

(11) **EP 1 303 015 A1**
(43) Date of publication of application: **16.04.2003**
(21) Application number: 02077205.9
(22) Date of filing: 06.06.2002
(51) Int. Cl.: H02B 1/56

(54) **Cabinet to house telecommunication equipment**

(30) Priority: 09.10.2001 BR 8102184 U
(71) Applicant: Nilko Metalurgia, Ltda., Piraquara-Parana (BR)
(72) Inventor: Huscher, Fraimundo, Piraquara-Paraná (Brazil) (BR)
(74) Representative: Manresa Val, Manuel

(57) **Abstract**

The present patent is described as a cabinet to house telecommunication equipment which, in accordance with the characteristics thereof, possesses as a principle the conditioning of telecommunication equipment in order to optimize and render safer the utilization and safekeeping thereof and having as a bases a cabinet (A) of great strength and versatility. The present cabinet (A) is formed by a set of mechanical and electrical solutions incorporated therein, comprising a complete cabinet (A) having its own characteristics, made of double plates of aluminum or the like, with double wall, plate/plate sandwich type closing, with spacers, possessing various proper and specific components arranged in the basic structure thereof, in order to incorporate a specific cabinet (A) performing the function of safekeeping telecommunication equipment, which are attached to the structure thereof, to guarantee the integrity during transportation and a perfect internal cooling.

## Description

The present patent relates to cabinets for telecommunications in general, more specifically to a cabinet to house telecommunication equipments which, according to the characteristics thereof, possesses as a basic principle the conditioning of telecommunication equipment in general, in order to optimize and provide a safe utilization and protection of the latter, being based on a cabinet having a robust, safe and versatile plate/plate type structure. With a specific design and shape, easily accessible for a better adaptation, comfort and safety for the users, practical handling, functionality and transportation characteristics and accessible cost and due to its characteristics and dimensions, is easily adaptable to any place and type of telecommunication equipment.

The patent in question is characterized in that it aggregates components and process in a differentiated concept with improvements and perfectioning. Such concept provides a cabinet having more functionality, economy, efficiency, safety and versatility, without prejudice to its technical qualities, thereby providing advantages and improvements to the product, the general characteristics of which differ from the other shapes and models known in the state of the art.

The present patent consists in the utilization of a modern, versatile, efficient and functional cabinet to house telecommunication equipment, formed by an assembly of properly incorporated mechanical and electrical solutions comprising a full cabinet with an exclusive design, optimum finish details and proprietary characteristics, made of double sheets of aluminum or the like, having equal or superior lightness and strength, with plate/plate sandwich-type closing system, double wall with spacers, having various proper and specific components perfectly arranged (fitted and attached) to the basis structure thereof, in order to incorporate a specific cabinet possessing not only the function of safekeeping (conditioning) of telecommunication equipment in general, which are properly fitted and attached to the internal structure thereof, in order to allow their perfect operation, but also to ensure their integrity during transportation to the user at the installation site and also a perfect and total internal refrigeration, to protect the conditioned equipment from temperature changes.

The present concept of a perfect internal refrigeration is based on the principle of internal ventilation by convection, which allows a better heat exchange, preventing internal condensation as a function of temperature changes and in an isolated ambient.

By the present cabinet to house telecommunication equipment, destined to house telecommunication equipment in general, last-generation technological solutions are incorporated thereto, thereby to provide an excellent quality and productivity level to the entire safekeeping process, mainly in the internal refrigeration part.

The present invention is based on the utilization of a cabinet comprising components and processes in a differentiated concept, thereby allowing to solve some of the main inconvenience of the other shapes and models to house telecommunication equipment in general, as known in the current state of the art, which are located in a work range wherein there is no proper maintenance at acceptable levels of the internal temperature change in relation to the outer temperature, no proper internal arrangement and access for the proper and safe fitting and attachment of the most diverse types of telecommunication equipment by the user, there is no safe and easy transportation capacity of the safekeeping means in general and no certainty of the durability and strength of the safekeeping means in general against undue violation and weathering in general, which causes a low productivity, fragility and difficult maintenance of the telecommunication equipment in general by the users.

The objects, advantages and other important characteristics of the patent in question can be more easily understood when read jointly with the appended drawings, wherein:

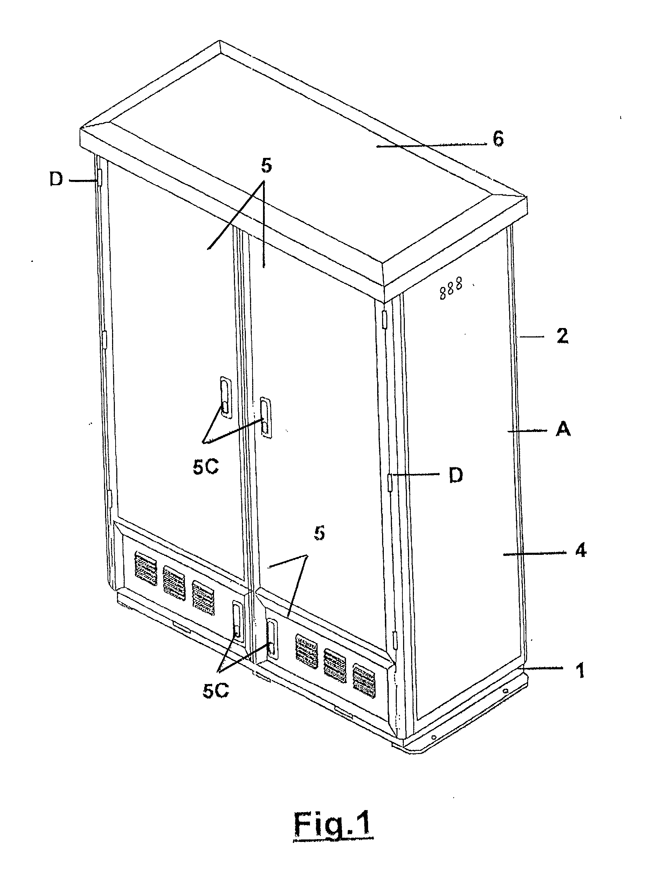

Figure 1 is a perspective view of the cabinet to house telecommunication equipment, in the four front door configuration.

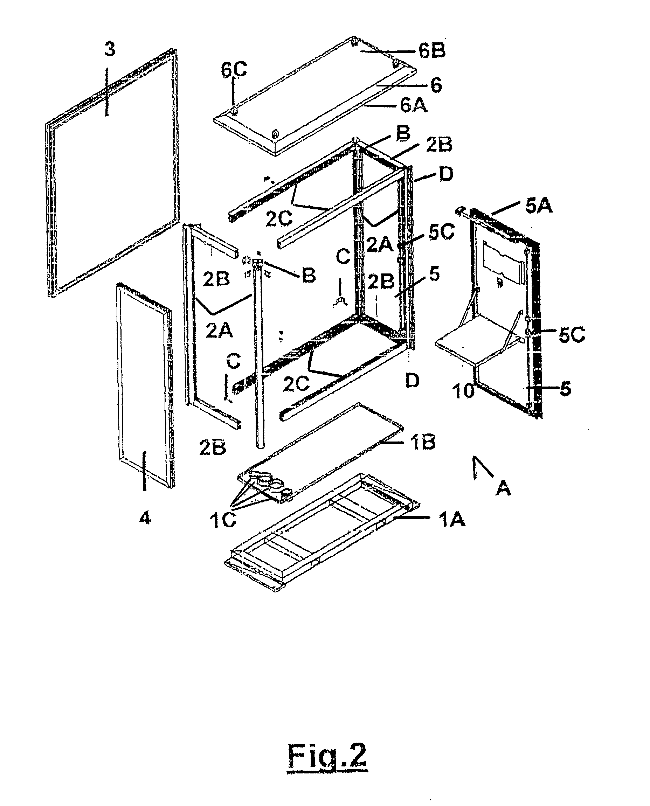

Figure 2 is an exploded perspective view of the cabinet to house telecommunication equipment in the configuration of two front doors and one side door.

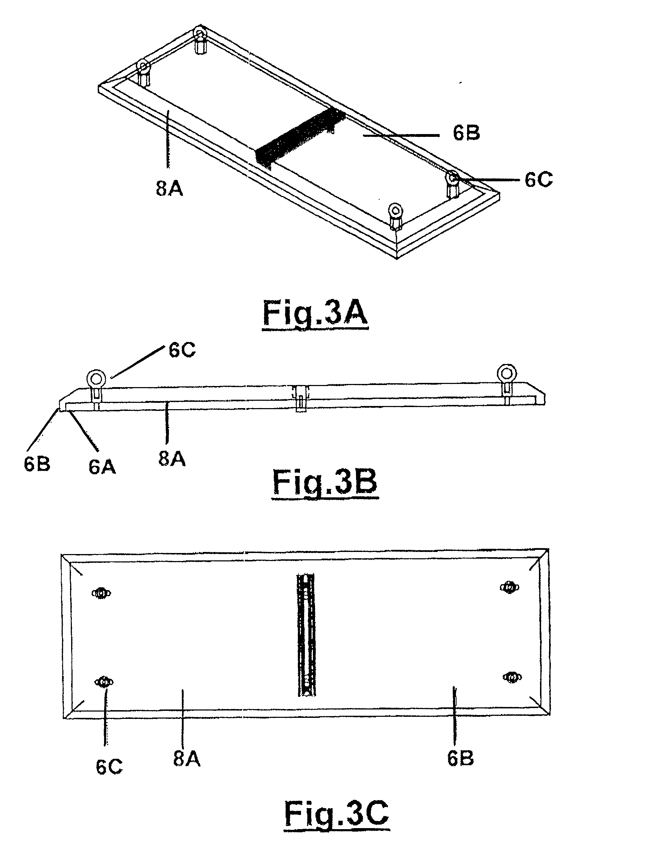

Figure 3A is a perspective view of the simple top cover with chamfered corners of the cabinet to house telecommunication equipment.
Figure 3B is a front view of the simple top cover with chamfered corners of the cabinet to house telecommunication equipment.
Figure 3C is an upper view of the simple top cover with chamfered corners of the cabinet to house telecommunication equipment.

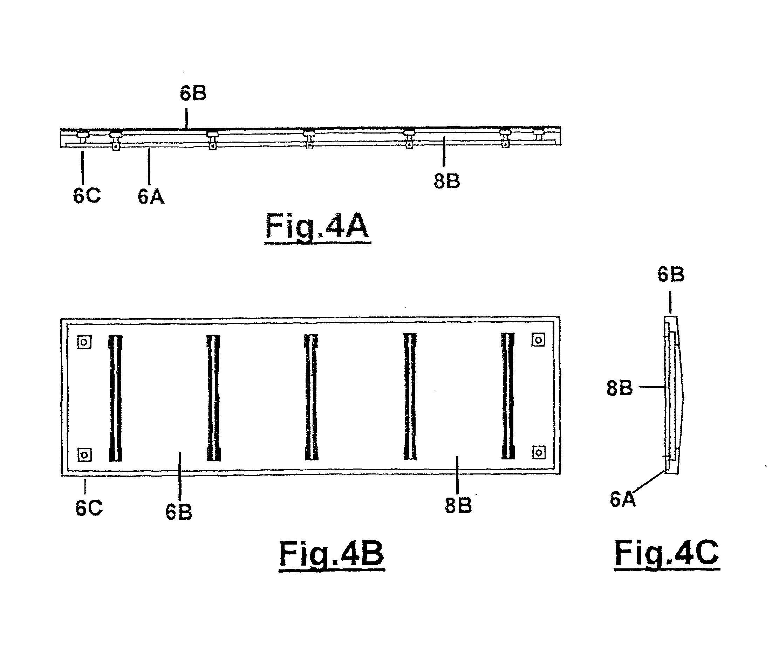

Figure 4A is a front view of the simple top cover with double-ramp roof of the cabinet to house telecommunication equipment.
Figure 4B is a top view of the simple top cover with double-ramp roof of the cabinet to house telecommunication equipment.
Figure 4C is a side view of the simple top cover with double-ramp roof of the cabinet to house telecommunication equipment.

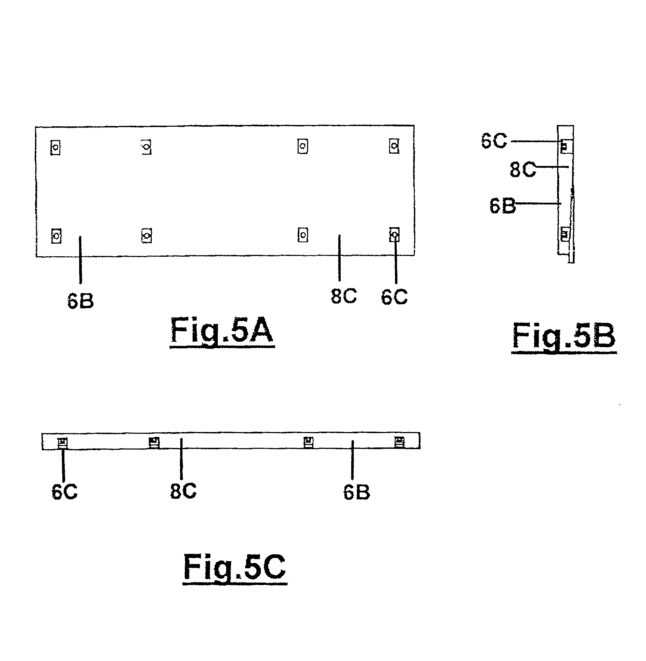

Figure 5A is an upper view of the simple top cover with single-ramp roof of the cabinet to house telecommunication equipment.
Figure 5B is a side view of the simple top cover with single-ramp roof of the cabinet to house telecommunication equipment.
Figure 5C is a front view of the simple top cover with single-ramp of the cabinet to house telecommunication equipment.

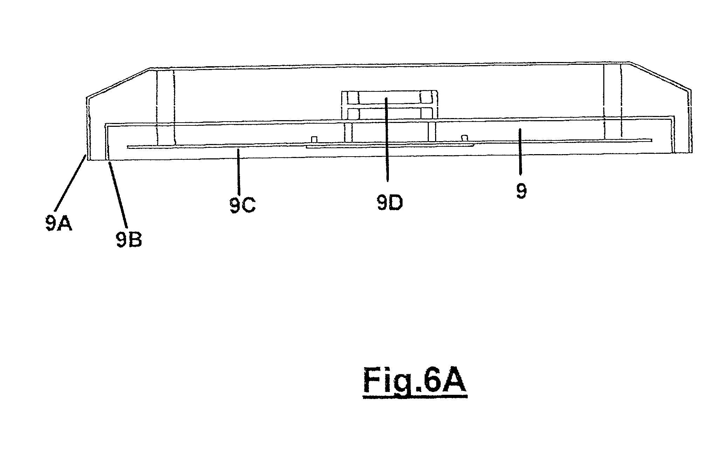

Figure 6A is a front sectional view of the active top cover of the cabinet to house telecommunication equipment.

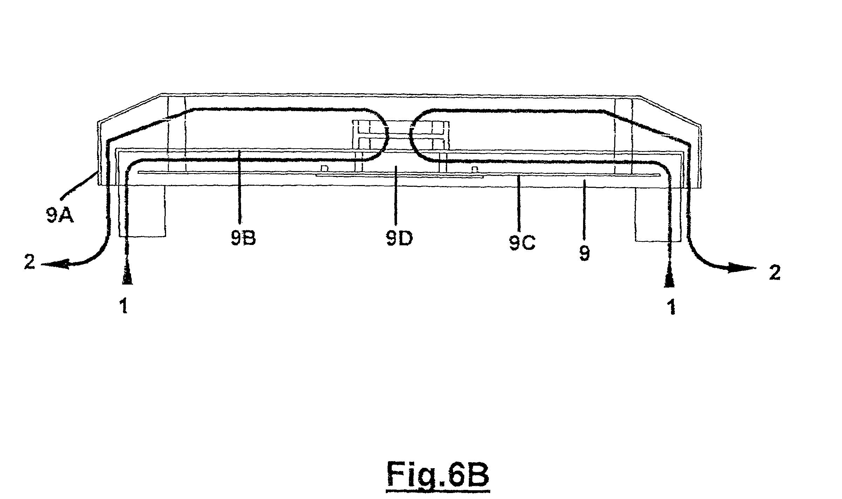

Figure 6B is a front sectional view of the active top cover of the cabinet to house telecommunication equipment, showing the operation scheme thereof.

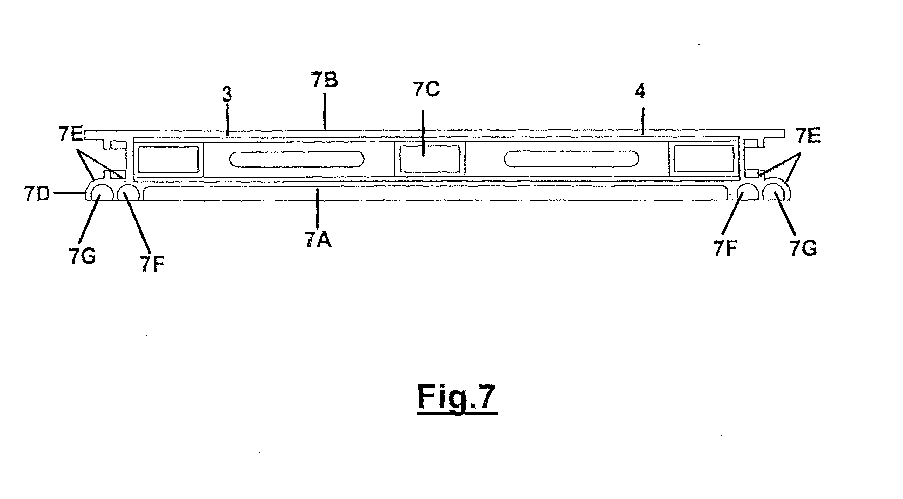

Figure 7 is an upper sectional view of the covers and doors of the cabinet to house telecommunication equipment.

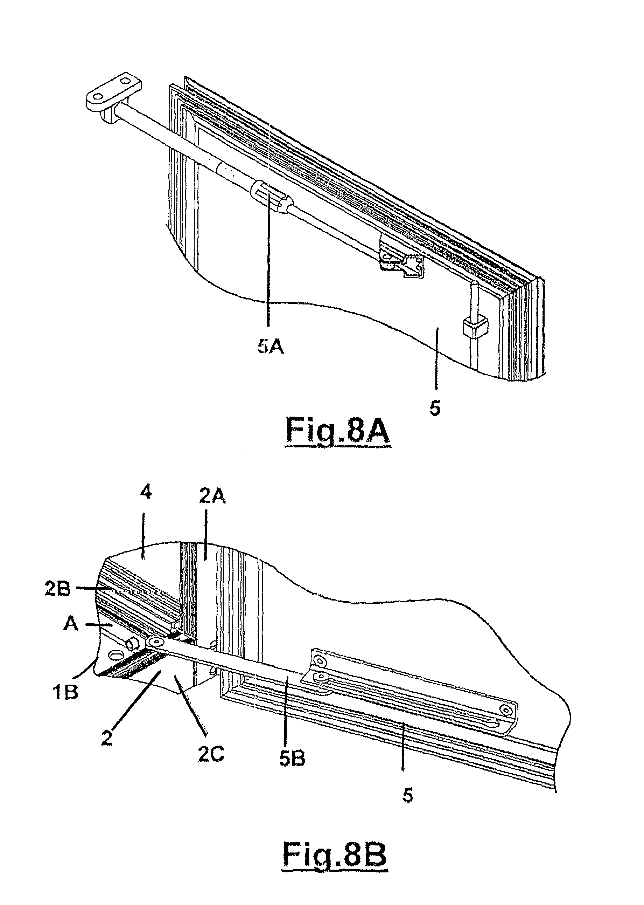

Figure 8A is a perspective view of the door stop of the cabinet to house telecommunication equipment.
Figure 8B is a perspective view of the mechanical door stop of the cabinet to house telecommunication equipment.

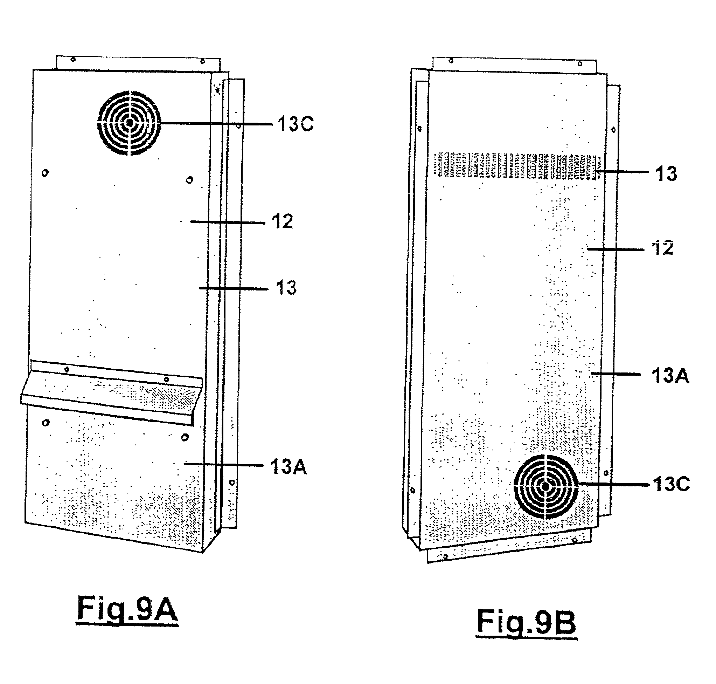

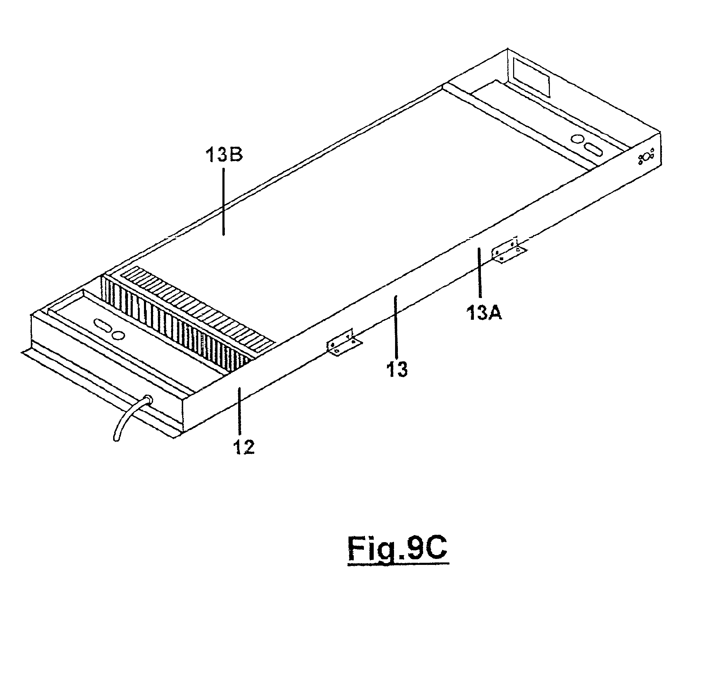

Figure 9A is a front perspective view of the heat exchanger of the cabinet to house telecommunication equipment.
Figure 9B is a rear perspective view of the heat exchanger of the cabinet to house telecommunication equipment.
Figure 9C is an upper sectional perspective view of the heat exchanger of the cabinet to house telecommunication equipment.

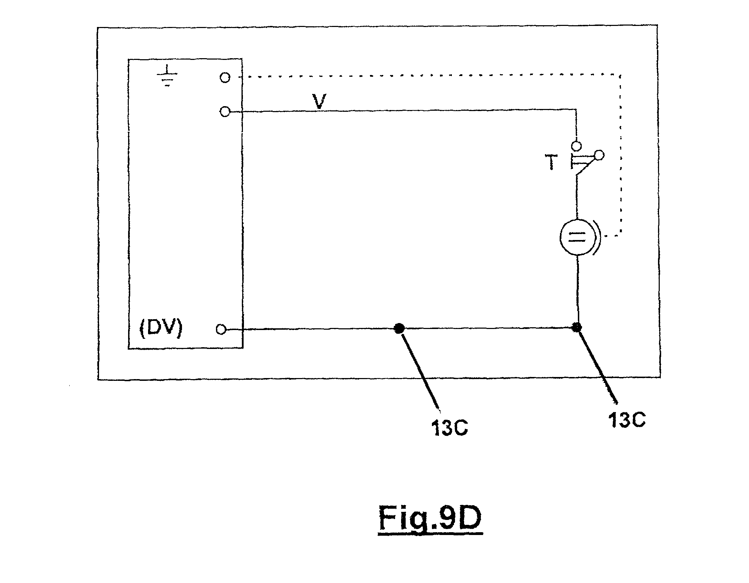

Figure 9D is a view of the electric scheme of the heat exchanger of the cabinet to house telecommunication equipment.

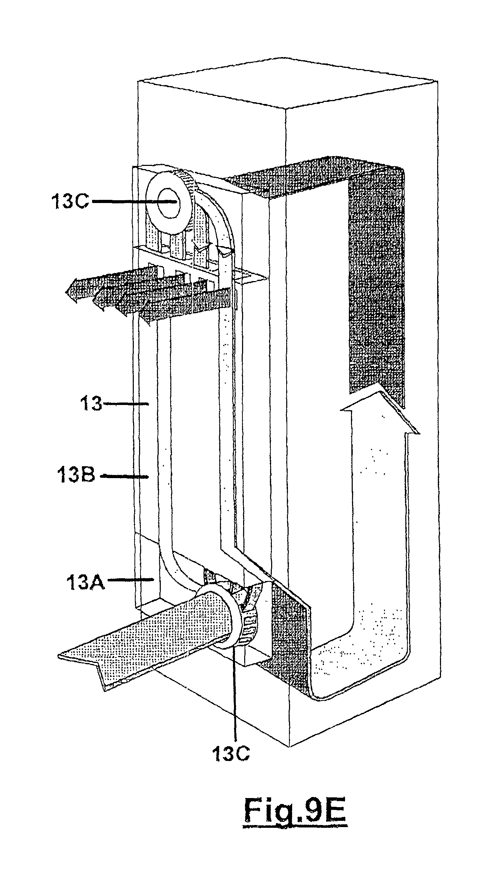

Figure 9E is a schematic perspective view of an heat exchanger installed externally of a cabinet to house telecommunication equipment, showing the general operation of the system.

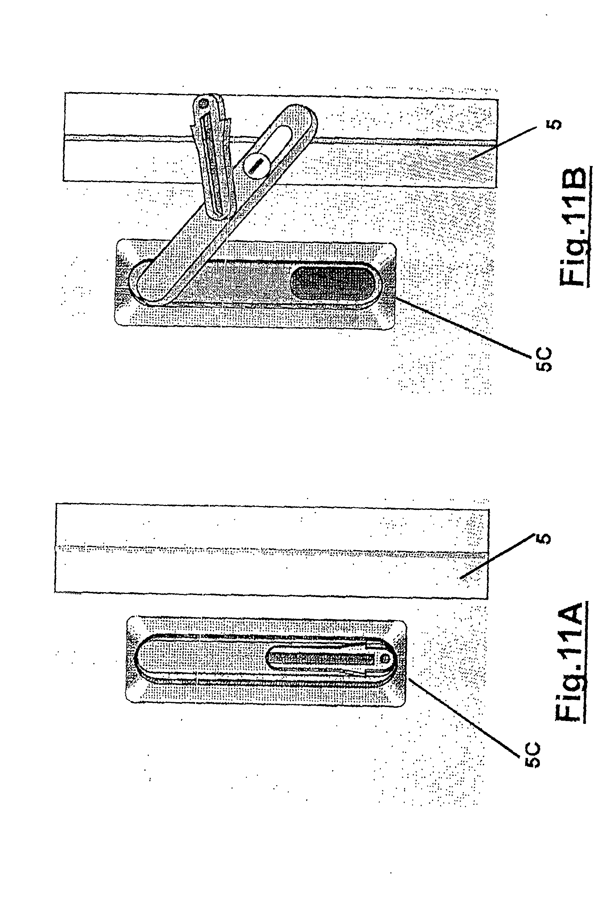

Figure 10A is a front perspective view of the door handle of the cabinet to house telecommunication equipment in the closed position.
Figure 10B is a front perspective view of the door handle of the cabinet to house telecommunication equipment.

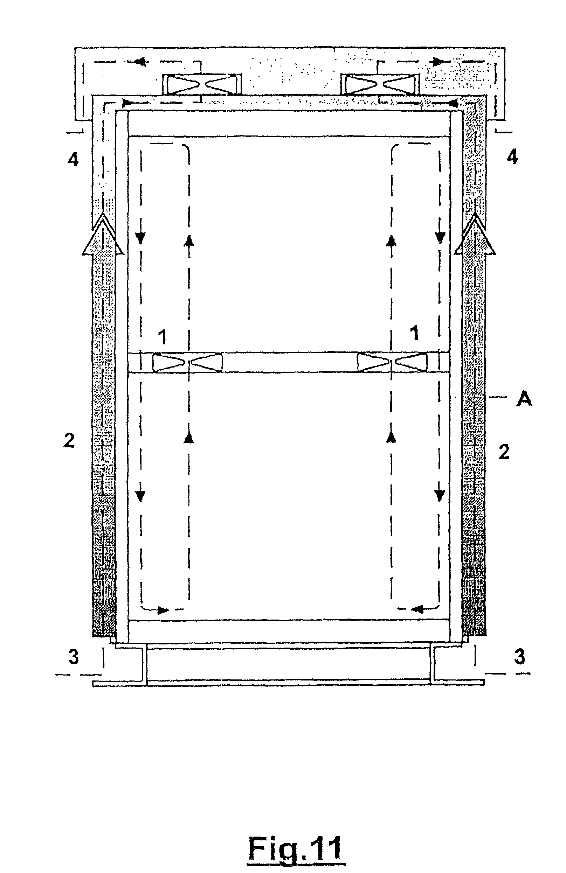

Figure 11 is a schematic view of the cabinet to house telecommunication equipment, equipped with an active top cover, showing the system's functionality to attain the heat exchange between the outer and inner environments.

As can be inferred from the appended drawings that illustrate and integrate the present description Figure (1) shows the same in a general manner, comprising a cabinet (A) having a generally high rectangular shape, made of double plates of aluminum or similar material having equal or higher lightness and strength with a venting orifice to minimize eventual moisture condensation, outer surfaces with powder polyester electrostatic painting and the inner ones without painting by reason of the equipment therein installed and comprised of a base (1) with a generally rectangular shape as a support for the entire assembly and containing a lower lifting base (1A) formed by an assembly of properly interconnected rectangular profiles and a lower tray (1B) formed by a small thickness plate attached to the lower lifting base (1A) and possessing in symmetrical alignment near one of the lateral sides thereof a set of cable holders/cable clamps (1C) of a generally circular shape and made of polymeric materials for passage of the most varied types of telecommunication cables, forming the floor proper and the cabinet support and attachment system (A), performing the function of isolating the inside of cabinet (A) from the environment, being of a great mechanical strength without suffering deformation; a support and holding structure (2) forming the central support and holding frame of the cabinet (A), containing four vertical columns (2A) attached vertically and symmetrically on the ends of base (1), four lateral columns (2B) horizontally and symmetrically attached between the upper and lower ends of the lateral faces of the vertical columns (2A) and four horizontal columns (2C) attached horizontally and symmetrically between the upper and lower ends of the front and rear lateral faces of the vertical columns (2A), both being formed by extruded, rectangular profiles and attached to each other by an attachment assembly (B) formed by spacers, corner plates, nuts and bolts; a rear cover (3) of generally rectangular shape as rear lining, properly attached vertically to the rear portion of the cabinet (A), between the vertical columns (2A) and the horizontal columns (2C), by means of an attachment assembly (C) formed by comer plates, nuts and bolts; lateral covers (4) of generally rectangular shape as lateral linings, properly attached vertically to the lateral portions of the cabinet (A), between the vertical columns (2A) and the lateral columns (2B), by means of an attachment assembly (C) formed by corner plates, nuts and bolts; front and lateral doors (5) of generally rectangular shapes as means for access to the inside of the cabinet (A), properly fitted and vertically attached to the frontal and lateral portions of cabinet (A), between the vertical columns (2A) and the horizontal columns (2C) by means of a set of hinges (D) attached between the front ends of the vertical columns (2A) and the inner ends of the front and lateral doors (5), the doors possessing a limitation to their opening and locking in the open position, by means of a adjustable damper (5A) attached between the lower face of the horizontal column (2C) or lateral column (2B) and the upper end of the inner face of the front and lateral doors (5), allowing an opening of up to one hundred and eighty degrees or a mechanical lock (5B) attached between the upper face of horizontal column (2C) or lateral column (2B) and the lower end of the inner face of the front and lateral doors (5), actuated by gravity and for locking of a rotating lock (5C) with a cylinder centered near the lateral end, provided with a key with standardized combination, being quite safe against violation and vandalism; and a cover plate (6) having a generally rectangular shape similar to a rimmed top, as an upper sealing means for the cabinet (A), properly fitted and horizontally attached to the upper portion of cabinet (A) on the upper lateral columns (2B) and the horizontal columns (2C), by means of an attachment set (E) formed by corner plates, nuts and bolts and containing an inner plate (6A), one outer plate (6B) and a profile or spacer (6C) attached to each other by bolts in order to allow a proper lifting of the cabinet (A).

The rear cover (3), the side covers (4) and the front and lateral covers (5) are comprised of a double, plate/plate sandwich, with spacers (rectangular pipes) to minimize the heat transfer effects between the outside and the inside, formed of a rectangular shape inner plate (7A), a rectangular shape outer plate (7B) having the same dimensions as the inner plate (7A); internal pipes (7C) (spacers) symmetrically spaced within the unfilled inner space for a perfect, parallel spacing of the inner (7A) and outer (7B) plates and to generate an air flow therebetween, and frame profiles (7D) of rectangular shape, arranged around the periphery of those parts (joints) to comprise an assembly, containing pairs of cylindrical shaped pairs of channels (7E) symmetrically arranged around the periphery thereof for electromagnetic shielding and as a seal against the penetration of dust and water (outer unit) with each pair of channels having fitted therein a rubber profile with metallic mesh (7F) or the like, of equal or higher strength and an EPDM rubber profile (7G) or the like of equal or higher strength, this being an important characteristic, as the cabinet (A) is to house electronic telecommunication equipment; with all inner (7A) and outer (7B) plates and the inner pipes (7C) glued and riveted, as shown on Figure (7).

The top cover (6) or hood can be comprised of an ordinary type hood without forced air input therein, with heat exchange in the inside thereof, and can be of the type with chamfered corners (8A), as shown on Figures (3A), (3B) and (3C) with a double slant (8B), as shown on Figures (4A), (4B) and (4C), and with a single slant (8C), as shown on Figures (5A), (5B) and (5C); or an active type hood (9) with forced air input therein and an air passage inside the rear (3) and lateral covers (4) and the front and lateral doors (5), being comprised of an outer plate (9A), an intermediate plate (9B), an inner plate (9C) and internal ventilators (9D) attached to the intermediate plate (9B), including the attachment and assembly parts thereof, as shown on Figure (6A).

The operation of the active cover hood (9) is based on its components and the proper arrangement thereof. The warm air coming from inside the closing plates of cabinet (A), as shown by arrow (1), penetrates the inside of the active type hood (9) through the lower face, between the intermediate (9B) and inner (9C) plates. Subsequently, it circulates inside the active type hood (9), between the external (9A) and intermediate (9B) plates, passing in a forced manner through the internal ventilators (9D) and exiting as ventilated air to the outer environment through the lower face, between the outer (9A) and intermediate (9B) plates, as shown by arrow (2). Accordingly, an air flow is generated inside the active type hood (9), as shown by line (3), caused by the internal ventilators (9D), as schematically shown on Figure (6B). The air from inside the closing panels is aspirated by the internal ventilators (9D).

The basic structure of cabinet (A) is provided with specific structural profiles containing channels allowing the insertion or lodging of threaded nuts, to which are attached the mechanical structures required for attachment of the equipment.

In other configurations and depending on the general use and application needs, the cabinet to house telecommunication equipment can be comprised of one or more specific lateral doors (5) instead of the lateral walls (3), as well as a varied number of front and lateral doors (5) in numbers and shapes in the front and lateral portions of cabinet (A).

The cabinet to house telecommunication equipment can be provided with various accessories for greater ease of the users, such as tilting shelves (1) embedded in the front and lateral doors (5) to support laptop computers; small front doors (11) and lateral doors (5); one independent operation box; small tilting doors near the front and lateral doors (5); and others, depending on the general needs and applications.

The cabinet to house telecommunication equipment can be installed in places having a relative variation in the ambient temperature, since upon operation, the equipment installed inside the cabinet (A) cannot be subjected to high temperatures, nor sudden temperature changes inside cabinet (A), wherein, due to its characteristics, the temperature does not exceed ten degrees Celsius. The heat exchange with the environment takes place in a gradual and continuous manner, aiming at guaranteed the total integrity of the electronic equipment contained inside the cabinet (A) and is based entirely in the general conception and general arrangement of the components thereof, mainly the rear (3) and lateral covers (4), the doors (5) and the top cover (6) (hood). As schematically shown on Figure (11), the operation of that heat variation in cabinet (A) takes place based on the conjunction of the inner circulation occurring in a circular manner inside the cabinet (A), as shown by lines (1); of the external circulation taking place in an ascending manner near and parallel to the rear (3) and lateral covers (4) and the doors (5), as shown by line (2); by the cold air (internal air flow) occurring in an ascending manner from the lower end of the rear (3) and lateral covers (4) and doors (5), penetrating therein, as shown by lines (3); and by the warm air (external air flow) taking place in an ascending manner near and parallel to the upper end of the rear (3) and lateral covers (4) and doors (5) and in a circular manner inside the top cover (6) (hood), exiting therefrom, as shown by lines (4). This internal refrigeration in the cabinet employs the principle of internal ventilation by convection, allowing a better heat exchange, preventing internal condensation, as a reason of temperature changes, and in an isolated ambient.

The heat exchange with the ambient can also take place in a gradual, continuous and forced manner, aiming at guaranteeing the total integrity of the electronic equipment contained inside cabinet (A), through the specific doors (12) with heat exchanger (13), as shown on Figures (9A) and (9B). These have been developed to perform the thermal dissipation generated inside cabinet (A), having as operating system the heat exchange between two air flows in countercurrent, separated by aluminum profiles of equal or higher lightness and strength.

The specific doors (12) with heat exchanger (13) assembled in a single structure having generally rectangular shapes are comprised of a basic structure (13A) comprised of aluminum and steel plates or the like, having equal or higher lightness and strength, treated with standard polyester powder painting; a heat dissipation hive (13B) centrally arranged therein as a filling and formed by the combination of aluminum profiles and plates or the like, having equal or higher lightness and strength, creating several air flow circulation channels, being assembled so as to facilitate the general maintenance thereof; two radial type ventilators (13C) with blades tilted back and forty-eight volt electric feed, as shown on Figure (9C), one being centrally arranged on the upper, outer portion and another on the lower, inner portion; and an electronic thermostat with a working temperature adjusting scale.

The internal flow starts with the aspiration of warm air on the top of the panel, being forced down through the heat dissipation hive (13B) and again blown into the cabinet (A). The flow starts with aspiration of the ambient temperature air at the lower portion of the heat exchanger (13), forcing the flow upwards through the heat dissipation hive (13B), as shown on Figure (9E).

The cabinet to house telecommunication equipment has the general characteristics and advantages of having the rear (3) and lateral covers (4), the doors (5) and the top cover (6) made with a double wall and ventilation and being fitted and/or attached, that is, fixed and/or removable; being capable of having tilting rear (3) and lateral (4), the doors (5) and the top cover (6), having upper and lower lifting points; floating nuts for internal assembly; and profile options for various internal assemblies and attachments.

For all of the above, this is an invention that will be well received by the companies employing cabinets for telecommunication equipment in general, since the present cabinet to house telecommunication equipment presents several advantages, such as: a great safety, reliability and easy conditioning of telecommunication equipment, since this is a high technology product; having excellent heat dissipation; great strength, flexibility and mobility; practical and safe maintenance; providing greater comfort, facility and safety to the users; lower wear of the assembly; accessible costs, which provides an optimum cost/benefit ratio; practical and safe assembly and installation; and the certainty of always having a cabinet (A) to house the most varied telecommunication equipment under optimum conditions.

Due to its general characteristics, the cabinet to house telecommunication equipment is of most useful, efficient and practical for companies making use of cabinets or other means to house the most varied types of telecommunication equipment in general, and can be employed in any public place, such as at the base of antennas, or public ways and installations in general; the sizes and dimensions may vary, depending on the use needs.

## Claims

1. Cabinet to house telecommunication equipment, **characterized in that** it comprises a cabinet (A) of generally high, rectangular shape, made of double plates of aluminum or a similar material having equal or higher lightness and strength with a venting orifice, outer surfaces painted with polyester powder electrostatic paint and the inner ones free of painting and comprised of a base (1) having a generally rectangular shape as a support for the entire assembly and containing a lower lifting base (1A) formed of an assembly of rectangular profiles perfectly interconnected and a lower tray (1B) formed of a small thickness plate attached on the lower lifting base (1A) possessing symmetrically aligned near one of the sides thereof a cable passage/cable presser assembly (1C) having a generally circular shape and made of polymeric materials, forming the floor proper and the system of support and attachment for the cabinet (A); a support structure (2) forming the central cabinet (A) support framework, containing four vertical columns (2A) attached vertically and symmetrically on the ends of base (1), four lateral columns (2B) attached horizontally and symmetrically between the upper and lower ends of the lateral faces of vertical columns (2A) and four horizontal columns (2C) attached horizontally and symmetrically between the upper and lower ends of the front and rear lateral faces of the vertical columns (2A), both formed of extruded profiles of rectangular shape and attached to each other by an attachment assembly (B) comprised of spacers, corner plates, nuts and bolts; one rear cover (3) having a generally rectangular shape as rear lining, perfectly and vertically attached to the rear portion of cabinet (A), between the vertical columns (2A) and the horizontal columns (2C) by an attachment assembly (C) comprised of corner plates, nuts and bolts; lateral covers (4) of generally rectangular shapes as lateral linings, perfectly attached vertically to the side portions of cabinet (A), between the vertical columns (2A) and the lateral columns (2B), through an attachment assembly (C) comprised of corner plates, nuts and bolts; front and lateral doors (5) of generally rectangular shapes as access means to the inside of cabinet (A), perfectly fitted and vertically attached to the front and lateral portions of cabinet (A), between the vertical columns (2A) and horizontal columns (2C), by a set of hinges (D) fixed between the front ends of the vertical columns (2A) and the inner ends of the front and lateral doors (5), the doors having an adjustable damper (5A) attached between the lower face of horizontal column (2C) or lateral column (2B) and the upper end of the inner face of the front and lateral doors (5), with an opening of up to one hundred and eighty degrees or a mechanical lock (5B) attached between the upper face of horizontal column (2C) or lateral column (2B) and the lower end of the inner face of the front or lateral doors (5), actuated by gravity and a rotating lock (5C) with a cylinder centered neat the lateral end, provided with a key with standard combination; and a top cover (6) having a generally rectangular shape, similar to a hood, as a means for upper sealing of the cabinet (A), perfectly fitted and horizontally attached to the upper portion of cabinet (A), on the lateral columns (2B) and the upper horizontal columns (2C), by means of an attachment assembly (E) comprised of corner plates, nuts and bolts and containing an inner plate (6A), an outer plate (6B) and a profile or spacer (6C) attached to each other by lifting bolts of cabinet (A); with the rear cover (3), the lateral covers (4) and the doors (5) being comprised of a double wall sandwich, a plate/plate, double wall sandwich closing system with spacers (rectangular pipes), formed of an inner plate (7A) of rectangular shape; an outer plate (7B) of rectangular shape, having the same dimensions as the inner plate (7A); internal pipes (7C) (spacers) symmetrically spaced in the unfilled inside parallel spacing of inner (7A) and outer (7B) plates with generation of an air flow therebetween; and frame profiles (7D) of rectangular shape arranged on the periphery of those parts (joints) to frame the assembly, containing pairs of channels (7E) of cylindrical shape and symmetrically arranged around the entire periphery thereof for electromagnetic shielding and sealing against the infiltration of powder and water (outer unit), with each pair of channels (7E) having therein a profile of rubber with metallic mesh (7F) or the like, having equal or higher strength and an EPDM rubber profile (7G) or the like of equal or higher strength, respectively, with all inner (7A) and outer (7B) plates and the inner pipes (7C) glued and riveted; and the basic structure of the cabinet (A) can be provided with specific structural profiles containing insertion or lodging grooves for threaded nuts, for attachment of the mechanical structures required for attachment of the equipment.

2. A cabinet in accordance with claim 1, **characterized in that** the top cover (6) or hood is comprised of a simple type hood without forced air input therein, with heat exchange therein, being of the type with chamfered corners (8A) with a double slant (8B) or a simple slant (8C); or an active type hood (9) with forced air input therein and air passage inside the rear (3) and lateral covers (4) and front and lateral doors (5), being comprised of an outer plate (9A), an intermediate plate (9B), an inner plate (9C) and internal ventilators (9D) attached to the intermediate plate (9B), including the parts for attachment and assembly thereof.

3. A cabinet in accordance with claim 1, **characterized in that** in other configurations and depending on the general use and application needs, it is comprised of one or more specific lateral doors (5) in lieu of the lateral covers (3), as well as a varied number of front and lateral doors (5) in numbers and shapes on the front and lateral portions of cabinet (A).

4. A cabinet in accordance with claim 1, **characterized in that** it contains several accessories such as tilting shelves (10) embedded in the front and lateral doors (5) to support laptop computers; small front doors (11) and lateral doors (5); one independent operation box; small tilting doors near the front and lateral doors (5); and others, depending on the needs.

5. A cabinet in accordance with claim 1, **characterized in that** it is comprised of specific doors (12) with heat exchanger (13) assembled in a single structure having generally rectangular shapes and comprised of a basic structure (13A) comprised of aluminum and steel plates or the like, of equal or higher lightness and strength, treated with standard polyester powder paint; a heat dissipation hive (13B) centrally arranged therein, as a filling and formed by the combination of profiles and plates of aluminum or the like, having equal or higher lightness and strength, thereby creating several air flow circulation channels, being assembled so as to facilitate the general maintenance thereof; two radial type ventilators (13C) with blades tilted back and forty-eight volt electrical feed, one being centrally arranged on the upper, outer portion and the other on the lower, inner portion; and a temperature regulation electronic thermostat.
